# EUROPÄISCHE PATENTSCHRIFT

(11) **EP 1 097 471 B1**
(45) Veröffentlichungstag und Bekanntmachung des Hinweises auf die Patenterteilung: **26.03.2008**
(21) Anmeldenummer: 99936280.9
(22) Anmeldetag: 19.05.1999
(51) Int. Cl.: H01L 21/00, H01L 27/108, H01L 21/8242

(54) **INTEGRIERTE SCHALTUNGSANORDNUNG MIT MINDESTENS EINEM TRANSISTOR UND EINEM KONDENSATOR UND VERFAHREN ZU DEREN HERSTELLUNG**
INTEGRATED CIRCUIT WITH AT LEAST ONE TRANSISTOR AND A CAPACITOR AND CORRESPONDING PRODUCTION METHOD
CIRCUIT INTEGRE COMPORTANT AU MOINS UN TRANSISTOR ET UN CONDENSATEUR, ET SON PROCEDE DE PRODUCTION

(30) Priorität: 19.05.1998 DE 19822500
(43) Veröffentlichungstag der Anmeldung: 09.05.2001
(73) Patentinhaber: Infineon Technologies AG, 81669 München (DE)
(72) Erfinder: HOFMANN, Franz, D-80995 München (DE); KRAUTSCHNEIDER, Wolfgang, D-83104 Hohenthann (DE)
(74) Vertreter: Epping - Hermann - Fischer
(86) Internationale Anmeldenummer: PCT/DE1999/001501
(87) Internationale Veröffentlichungsnummer: WO 1999/060608

(56) Entgegenhaltungen:
- US-A- 5 307 310
- US-A- 5 429 976
- US-A- 5 497 017
- PATENT ABSTRACTS OF JAPAN vol. 17, no. 140 (E-1336), 22. März 1993 (1993-03-22) & JP 04 309261 A (SONY CORP), 30. Oktober 1992 (1992-10-30)

## Beschreibung

Die Erfindung betrifft eine integrierte Schaltungsanordnung mit mindestens einem Transistor und einem Kondensator gemäß dem Oberbegriff des Patentanspruchs 1 sowie ein Verfahren zu deren Herstellung.

Derartige Schaltungsanordnungen sind beispielsweise aus der US 5,429,976 oder der US 5,497,017 bekannt. So zeigt die erstgenannte Druckschrift ein Verfahren zur Erzeugung von selbstausgerichteten Wortleitung auf Gate-Elektroden, um die Kapazität von Speicherkondensatoren zu erhöhen.

Im Hinblick auf immer schnellere Bauelemente bei höherer Integrationsdichte nehmen die Strukturgrößen integrierter Schaltungsanordnungen von Generation zu Generation ab. Die integrierten Schaltungsanordnungen werden derzeit meist in einer planaren Siliziumtechnologie realisiert, bei der die Bauelemente nebeneinander angeordnet und über mehrere Metallisierungsebenen miteinander verbunden sind.

Umfaßt eine integrierte Schaltungsanordnung einen Transistor, so läßt sich ihre Packungsdichte erhöhen, indem der Transistor als vertikaler Transistor ausgebildet wird. In L.Risch et al., Vertical MOS-Transistors with 70 nm Channel Length, ISSDERC 1995, Seiten 101 bis 104, werden vertikale MOS-Transistoren beschrieben, bei denen zu ihrer Herstellung Schichtenfolgen mit Schichten entsprechend Source, Kanal- und Drain gebildet und ringförmig von einer Gateelektrode umgeben werden.

Eine weitere Möglichkeit die Packungsdichte einer integrierten Schaltungsanordnung zu erhöhen, besteht darin, zwei Bauelemente übereinander anzuordnen. In der deutschen Patentschrift 195 19 160 C1 ist eine DRAM-Zellenanordnung vorgeschlagen worden, bei der ein Speicherkondensator über einem Auswahltransistor angeordnet ist. Ein erstes Source/Drain-Gebiet, ein darunter angeordnetes Kanalgebiet und ein darunter angeordnetes zweites Source/Drain-Gebiet des Auswahltransistors sind Teile einer vorsprungsartigen Halbleiterstruktur, die von einer Gateelektrode ringförmig umgeben ist. Aneinander angrenzende Gateelektroden bilden Wortleitungen. Das erste Source/Drain-Gebiet wirkt auch als erste Kondensatorelektrode des Speicherkondensators. Über der ersten Kondensatorelektrode ist ein Kondensatordielektrikum und darüber eine zweite Kondensatorelektrode angeordnet, die als gemeinsame Kondensatorplatte aller Speicherkondensatoren der DRAM-Zellenanordnung wirkt. Die Fläche einer Speicherzelle der DRAM-Zellenanordnung kann 4*F*² betragen, wobei F die minimale, in der verwendeten Technologie herstellbare Strukturgröße ist.

Der Erfindung liegt das Problem zugrunde, eine integrierte Schaltungsanordnung mit mindestens einem Transistor und einem Kondensator anzugeben, bei der ein erstes Source/Drain-Gebiet des Transistors mit einer ersten Kondensatorelektrode des Kondensators verbunden ist, bei der der Kondensator eine hohe Kapazität aufweist und die trotzdem mit hoher Packungsdichte herstellbar ist. Ferner soll ein Herstellungsverfahren für eine solche integrierte Schaltungsanordnung angegeben werden.

Dieses Problem wird gelöst durch eine integrierte Schaltungsanordnung gemäß Anspruch 1 und ein Verfahren gemäß Anspruch 9. Weitere Ausgestaltungen der Erfindung gehen aus den übrigen Ansprüchen hervor.

Bei einer erfindungsgemäßen integrierten Schaltungsanordnung sind eine Struktur, über die ein Transistor ansteuerbar ist, und eine strukturierte leitende Schicht, die Teil einer ersten Kondensatorelektrode eines Kondensators ist, übereinander angeordnet. Eine isolierende Schicht trennt die Struktur, über die der Transistor ansteuerbar ist, von der leitenden Schicht. Durch das Übereinanderanordnen der leitenden Schicht und der Struktur, über die der Transistor ansteuerbar ist, erhöht sich die Packungsdichte der Schaltungsanordnung im Vergleich zu Ausführungen des Standes der Technik, bei denen die erste Kondensatorelektrode und die Struktur, über die der Transistor ansteuerbar ist, nebeneinander angeordnet sind.

Als weiterer Teil der ersten Kondensatorelektrode ist eine vertikale leitende Struktur vorgesehen, die mit einem ersten Bereich die leitende Schicht seitlich überlappt, an einem zweiten Bereich durch eine isolierende Struktur von der Struktur, über die der Transistor ansteuerbar ist, isoliert ist und mit einem dritten Bereich ein erstes Source/Drain-Gebiet des Transistors überlappt, wobei der zweite Bereich zwischen dem ersten Bereich und dem dritten Bereich angeordnet ist. Der erste Bereich, der zweite Bereich und der dritte Bereich der vertikalen leitenden Struktur sind bezüglich einer vertikalen Achse, d.h. einer zu den Schichtebenen vertikalen Achse, übereinander angeordnet. Die isolierende Struktur grenzt seitlich an die Struktur, über die der Transistor ansteuerbar ist, an. Der zweite Bereich der vertikalen leitenden Struktur grenzt seitlich an die isolierende Struktur an. An die leitende Schicht und an die vertikale leitende Struktur grenzt ein Kondensatordielektrikum an, an das wiederum eine zweite Kondensatorelektrode des Kondensators angrenzt. Aufgrund der vertikalen leitenden Struktur ist eine effektive Oberfläche der ersten Kondensatorelektrode größer als ihre Projektion auf eine horizontale Ebene, was sehr vorteilhaft ist, da sich eine Kapazität des Kondensators erhöhen läßt, ohne die Packungsdichte der Schaltungsanordnung zu verkleinern.

Darüber hinaus ergibt sich eine besonders hohe Packungsdichte der Schaltungsanordnung dadurch, daß mindestens eine Flanke der Struktur, über die der Transistor ansteuerbar ist, ausgenutzt wird, um die Oberfläche der ersten Kondensatorelektrode zu vergrößern.

Vorteilhaft ist ferner, daß die vertikale leitende Struktur die Verbindung zwischen dem ersten Source/Drain-Gebiet des Transistors und der leitenden Schicht erlaubt, obwohl von der Höhe her, d.h. bezüglich der vertikalen Achse, zwischen ihnen die Struktur, über die der Transistor ansteuerbar ist, angeordnet ist.

Unter "Spacer" wird eine Struktur verstanden, die sich an einer seitlichen Fläche einer zumindest näherungsweise stufenförmigen Struktur ausbildet, wenn Material im wesentlichen konform abgeschieden und anisotrop rückgeätzt wird, bis horizontale Flächen der stufenförmigen Struktur freigelegt werden.

Es ist vorteilhaft, die vertikale leitende Struktur als Spacer auszubilden, da der Spacer eine geringe horizontale Abmessung aufweist, und sich so eine besonders hohe Packungsdichte erzielen läßt. Die Verbindung zwischen dem ersten Source/Drain-Gebiet des Transistors und der leitenden Schicht nimmt eine besonders kleine horizontale Fläche ein, weshalb auch ein horizontaler Querschnitt des Kondensators oder des ersten Source/Drain-Gebiets klein ausfallen kann.

Der Transistor kann höher als die leitende Schicht angeordnet sein. In diesem Fall ist der dritte Bereich der vertikalen leitenden Struktur höher als der erste Bereich der vertikalen leitenden Struktur angeordnet.

Der Transistor kann tiefer als die leitende Schicht angeordnet sein. In diesem Fall ist der erste Bereich der vertikalen leitenden Struktur höher als der dritte Bereich der vertikalen leitenden Struktur angeordnet.

Die Struktur, über die der Transistor ansteuerbar ist, kann eine Gateelektrode des Transistors sein. In diesem Fall ist die Gateelektrode in vertikaler Richtung zwischen einem mit einem Gatedielektrikum versehenen Kanalgebiet des Transistors und dem Kondensator angeordnet. Das Kanalgebiet ist in horizontaler Richtung zwischen dem ersten Source/Drain-Gebiet und einem zweiten Source/Drain-Gebiet des Transistors angeordnet. Die leitende Schicht ist über dem Transistor angeordnet, und der dritte Bereich der vertikalen leitenden Struktur grenzt mit einer unteren, im wesentlichen horizontalen Fläche an das erste Source/Drain-Gebiet an.

Alternativ ist die Struktur, über die der Transistor ansteuerbar ist, nicht die Gateelektrode an sich sondern lediglich mit der Gateelektrode verbunden. In diesem Fall kann die Struktur, über die der Transistor ansteuerbar ist, zwischen dem ersten Source/Drain-Gebiet und dem Kondensator angeordnet sein. Der Transistor und die leitende Schicht sind also übereinander angeordnet. Die Struktur, über die der Transistor ansteuerbar ist, ist durch eine weitere isolierende Schicht vom ersten Source/Drain-Gebiet getrennt.

Eine besonders hohe Packungsdichte läßt sich erzielen, wenn die vertikale leitende Struktur an eine erste Flanke des ersten Source/Drain-Gebiets und an eine erste Flanke der ersten Kondensatorelektrode angrenzt.

Ragt das erste Soürce/Drain-Gebiet beim dritten Bereich der vertikalen leitenden Struktur in horizontaler Richtung über die isolierende Struktur hinaus, und liegt das erste Source/Drain-Gebiet tiefer als die leitende Schicht, so kann der dritte Bereich der vertikalen leitenden Struktur mit der unteren Fläche an das erste Source/Drain-Gebiet angrenzen. Umgekehrt kann der erste Bereich mit seiner unteren Fläche an die leitende Schicht angrenzen, wenn die leitende Schicht beim ersten Bereich der vertikalen leitenden Struktur in horizontaler Richtung über die isolierende Struktur hinausragt, und der Kondensator tiefer als das erste Source/Drain-Gebiet liegt.

Damit die horizontale Abmessung der vertikalen leitenden Struktur möglichst klein sein kann und die erste Flanke des ersten Source/Drain-Gebiets und die erste Flanke der leitenden Schicht überlappen kann, ist es vorteilhaft, wenn besagte Flanken im wesentlichen parallel zueinander sind und in horizontaler Richtung einen nicht zu großen Abstand voneinander aufweisen. Der Abstand ist vorzugsweise etwa gleich der horizontalen Abmessung der isolierenden Struktur.

Zur Erhöhung der Packungsdichte ist es vorteilhaft, wenn die horizontale Abmessung der isolierenden Struktur gering ist. Die isolierende Struktur ist beispielsweise spacerförmig. Alternativ kann die isolierende Struktur durch thermische Oxidation einer Flanke der Struktur, über die der Transistor ansteuerbar ist, an die die vertikale leitende Struktur angeordnet wird, erzeugt werden.

Liegt der Transistor tiefer als die leitende Schicht, so muß insbesondere bei der thermischen Oxidation dafür gesorgt werden, daß die isolierende Struktur nicht das gesamte erste Source/Drain-Gebiet bedeckt, da sonst die vertikale leitende Struktur nicht direkt an das erste Source/Drain-Gebiet angrenzen kann. Eine Möglichkeit dafür zu sorgen besteht darin, das erste Source/Drain-Gebiet nach Erzeugung der isolierenden Struktur durch Strukturierung eines leitenden Gebiets zu erzeugen, wobei selektiv zur isolierenden Struktur geätzt wird. Dadurch entsteht die erste Flanke des ersten Source/Drain-Gebiets nach Erzeugung der isolierenden Struktur, und die vertikale leitende Struktur kann angrenzend an das erste Source/Drain-Gebiet erzeugt werden. Liegen die erste Flanke der leitenden Schicht und die Flanke der Struktur, über die der Transistor ansteuerbar ist, in derselben Ebene, so liegen die erste Flanke der leitenden Schicht und die erste Flanke des ersten Source/Drain-Gebiets nicht in derselben Ebene, da selektiv zur isolierenden Struktur, die an die Flanke der Struktur, über die der Transistor ansteuerbar ist, angrenzt und eine endliche horizontale Abmessung besitzt, geätzt wird.

Das leitende Gebiet kann z.B. als dotiertes Gebiet in einem Substrat, das Halbleitermaterial enthält, realisiert sein.

Im folgenden wird ein vorteilhaftes Verfahren beschrieben, bei dem der Kondensator, die Struktur, über die der Transistor ansteuerbar ist, und das erste Source/Drain-Gebiet selbstjustiert, d.h. ohne Verwendung von zu justierenden Masken, übereinander erzeugt werden.

An einer Oberfläche des Substrats wird das leitende Gebiet erzeugt. Mindestens eine erste isolierende Schicht, eine erste leitende Schicht, eine zweite isolierende Schicht und eine zweite leitende Schicht, die mit der oben erwähnten leitenden Schicht übereinstimmt, werden erzeugt. Eine Vertiefung, die mindestens die erste leitende Schicht durchtrennt, wird erzeugt. Die erste isolierende Schicht kann dabei als Ätzstop dienen. Ein isolierendes Material wird abgeschieden und so weit rückgeätzt, daß die spacerförmige isolierende Struktur entsteht, die die erste leitende Schicht seitlich bedeckt. Die Vertiefung wird vertieft, so daß das Gebiet durchtrennt wird, wobei selektiv zur isolierenden Struktur geätzt wird. Durch Abscheiden und anisotropem Rückätzen von leitendem Material wird die vertikale leitende Struktur erzeugt, die das Gebiet, die isolierende Struktur und die zweite leitende Schicht überlappt. Aus der zweiten leitenden Schicht und der vertikalen leitenden Struktur wird die erste Kondensatorelektrode des Kondensators, aus der ersten leitenden Schicht wird die Struktur, über die der Transistor ansteuerbar ist, und aus dem Gebiet wird das erstes Source/Drain-Gebiet des Transistors erzeugt. Je tiefer die Vertiefung ist, umso größer ist die Oberfläche der ersten Kondensatorelektrode und umso höher ist die Kapazität des Kondensators.

Ist die integrierte Schaltungsanordnung eine Speicherzellenanordnung, z.B. eine DRAM-Zellenanordnung, so kann die Struktur, über die der Transistor ansteuerbar ist, eine Wortleitung sein. Speicherzellen der Speicherzellenanordnung umfassen jeweils einen Transistor und einen Kondensator, die über eine vertikale leitende Struktur miteinander verbunden sind.

Ein zweites Source/Drain-Gebiet des Transistors ist mit einer Bitleitung verbunden.

Alternativ dient die Struktur, über die der Transistor ansteuerbar ist, der Verbindung des Transistors mit einem anderen Bauelement.

Es ist vorteilhaft, den Transistor als planaren Transistor auszubilden, da in diesem Fall die Standardtechnologie zur Erzeugung des Transistors verwendet werden kann.

Zur Erhöhung der Packungsdichte ist es vorteilhaft, wenn der Transistor als vertikaler Transistor ausgebildet ist. Der Transistor ist beispielsweise unter der leitenden Schicht angeordnet. In diesem Fall ist unter dem ersten Source/Drain-Gebiet ein Kanalgebiet des Transistors angeordnet. Die Gateelektrode ist an einer durch das Kanalgebiet gebildeten Fortsetzung einer zweiten Flanke des ersten Source/Drain-Gebiets angeordnet. Die Gateelektrode ist durch ein Gatedielektrikum vom Kanalgebiet getrennt und ist mit der Struktur, über die der Transistor ansteuerbar ist, verbunden.

Es liegt im Rahmen der Erfindung, wenn die Wortleitung parallel zur ersten Flanke des ersten Source/Drain-Gebiets und zur Oberfläche des Substrats verläuft. Zur Erhöhung der Packungsdichte ist es in diesem Fall vorteilhaft, wenn die zweite Flanke des ersten Source/Drain-Gebiets, an die erste Flanke des ersten Source/Drain-Gebiets, an die die vertikale leitende Struktur angrenzt, angrenzt. Die zweite Flanke des ersten Source/Drain-Gebiets ist mit einer Isolation versehen, die die Gateelektrode vom ersten Source/Drain-Gebiet elektrisch isoliert. Die Gateelektrode ist unter der Wortleitung angeordnet, was die Packungsdichte erhöht. Die Gateelektrode kann zusammen mit der Wortleitung erzeugt werden und ist dann eine vertikale Ausstülpung der Wortleitung.

Die Isolation und das Gatedielektrikum können zusammenhängen und gleichzeitig erzeugt werden. Die Isolation und das Gatedielektrikum können Teile der ersten isolierenden Schicht sein.

Zur Verringerung einer Kapazität, die durch die Gateelektrode bzw. der Struktur, über die der Transistor ansteuerbar ist, und das erste Source/Drain-Gebiet gebildet wird, ist es für den Fall, daß die Isolation und das Gatedielektrikum Teile der ersten isolierenden Schicht sind, vorteilhaft, wenn nicht als Gatedielektrikum wirkende Teile der ersten isolierenden Schicht dicker sind als das Gatedielektrikum. Dies ist beispielsweise der Fall, wenn die erste isolierende Schicht durch thermische Oxidation erzeugt wird, da im Bereich höher dotierter Gebiete die thermische Oxidation schneller voranschreitet, und das resultierende Oxid dicker ist als bei niedrig dotierten Gebieten.

Zur Prozeßvereinfachung, zur Erhöhung der Kapazität des Kondensators und zur besseren Kontaktierung ist es vorteilhaft, wenn eine zur vertikalen leitenden Struktur analoge weitere vertikale leitende Struktur, die das erste Source/Drain-Gebiet mit der leitenden Schicht verbindet, an eine dritte, der ersten Flanke gegenüberliegenden Flanke des ersten Source/Drain-Gebiets angrenzt.

Es können erste Gräben vorgesehen sein, die quer zur Wortleitung verlaufen und die zwischen den ersten Source/Drain-Gebieten der Transistoren angeordnet sind. Die Gateelektroden sind in den ersten Gräben angeordnet. Damit die Gateelektrode nicht zwei verschiedene Transistoren ansteuert, grenzen an erste Flanken der ersten Gräben mindestens im Bereich von Kanalgebieten der Transistoren Strukturen an, die die Ausbildung von Kanälen verhindern. Dies ist gleichbedeutend damit, daß an eine vierte, der zweiten Flanke des ersten Source/Drain-Gebiets gegenüberliegende Flanke des ersten Source/Drain-Gebiets, sowie an dessen durch das Kanalgebiet gebildete Fortsetzung eine der Strukturen, die die Ausbildung von Kanälen verhindern, angrenzt.

Die Strukturen, die die Ausbildung von Kanälen verhindern, können in Form von Channel-Stop-Gebieten gebildet werden, indem die ersten Flanken der ersten Gräben durch schräge Implantation höher dotiert werden, als die Kanalgebiete. Dies kann mit oder ohne Maske erfolgen. Wird eine Maske verwendet, so bedeckt sie z.B. Teile der ersten Flanken der ersten Gräben, an denen die Gateelektroden nicht angeordnet werden.

Alternativ können die Strukturen, die die Ausbildung von Kanälen verhindern, aus isolierendem Material erzeugt werden. Dazu kann das isolierende Material so abgeschieden werden, daß die ersten Gräben gefüllt werden..Anschließend wird das isolierende Material z.B. durch ein fotolithographisches Verfahren mindestens von Teilen der zweiten Flanken der ersten Gräben, an denen die Gateelektroden angeordnet werden, entfernt, wodurch die Strukturen, die die Ausbildung von Kanälen verhindern, erzeugt werden.

Eine dabei verwendete Maske kann streifenförmig sein, wobei ihre Streifen parallel zu den ersten Gräben verlaufen und die ersten Flanken der ersten Gräben bedecken. Alternativ bedeckt die Maske rechteckige Gebiete, die die Teile der zweiten Flanken der ersten Gräben, an denen die Gateelektroden angeordnet werden, überlappen, nicht. Dies ist besonders vorteilhaft, da falls die Wortleitungen durch Abscheiden und Strukturieren von leitendem Material erzeugt werden, das leitende Material nicht bis an die Böden der ersten Gräben geätzt werden muß.

Damit die Wortleitungen durch Abscheiden und Strukturieren von leitendem Material erzeugt werden können, ist es vorteilhaft, das isolierende Material, mit dem die ersten Gräben gefüllt werden, vor Erzeugung der Strukturen, die die Ausbildung von Kanälen verhindern, zu planarisieren, bis die Oberfläche des Substrats und damit die ersten Source/Drain-Gebiete freigelegt werden, und außerhalb der ersten Gräben nichts vom isolierenden Material vorhanden ist.

Die Vertiefung, in der die vertikale leitende Struktur angeordnet ist, kann Teil eines von quer zu den ersten Gräben verlaufenden zweiten Gräben sein. Die ersten Source/Drain-Gebiete sind durch die ersten Gräben und die zweiten Gräben voneinander getrennt. Die Wortleitungen können durch die Erzeugung der zweiten Gräben erzeugt werden. Wird in diesem Fall bei der Erzeugung der Strukturen, die die Ausbildung von Kanälen verhindern, die streifenförmige Maske verwendet, so entstehen in Gebieten, in denen sich die ersten Gräben und die zweiten Gräben kreuzen, weitere Vertiefungen. Es ist vorteilhaft, diese weiteren Vertiefungen durch Abscheiden und Rückätzen von isolierendem Material zu füllen.

Im folgenden wird ein vorteilhaftes Verfahren beschrieben, bei dem der Kondensator, die Wortleitung und das erste Source/Drain-Gebiet selbstjustiert, d.h. ohne Verwendung von zu justierenden Masken, übereinander erzeugt werden. An der Oberfläche des Substrats wird ein Gebiet, das zwischen den ersten Gräben angeordnete Streifen umfaßt, erzeugt. Nach Erzeugung der Strukturen, die die Ausbildung von Kanälen verhindern, und der ersten isolierenden Schicht, die teilweise als Gatedielektrikum wirkt und die auch die Oberfläche des Substrats bedeckt, werden eine erste leitende Schicht, darüber eine zweite isolierende Schicht und darüber eine zweite leitende Schicht abgeschieden. Durch die Erzeugung der zweiten Gräben, die bis zur ersten isolierenden Schicht reichen, entstehen aus der ersten leitenden Schicht die Wortleitungen. Nach der Erzeugung der zweiten Gräben wird isolierendes Material abgeschieden und rückgeätzt, wodurch die isolierenden Strukturen in Form von Spacern entstehen. Anschließend werden die zweiten Gräben vertieft, wobei selektiv zu den isolierenden Strukturen geätzt wird. Dabei wird das Gebiet durchtrennt. Aus dem Gebiet entstehen die ersten Source/Drain-Gebiete. Falls die isolierenden Strukturen Flanken der strukturierten zweiten leitenden Schicht bedecken, werden die isolierenden Strukturen rückgeätzt, bis die besagten Flanken zumindest teilweise freiliegen. Zur Erzeugung der vertikalen leitenden Strukturen wird leitendes Material abgeschieden und rückgeätzt. Die vertikalen leitenden Strukturen bedecken die Flanken der zweiten leitenden Schicht und die ersten und dritten Flanken der ersten Source/Drain-Gebiete. Anschließend werden mit Hilfe einer Maske, die mit der Maske für die Erzeugung der ersten Gräben übereinstimmt, die zweite leitende Schicht und die vertikalen leitenden Strukturen strukturiert. Dabei entstehen aus der zweiten leitenden Schicht und den vertikalen leitenden Strukturen die voneinander getrennten ersten Kondensatorelektroden. Teile der strukturierten zweiten leitenden Schicht werden jeweils von zwei der vertikalen leitenden Strukturen kontaktiert. Dasselbe trifft auf die ersten Source/Drain-Gebiete zu. Über den ersten Kondensatorelektroden werden ein Kondensatordielektrikum und darüber weiteres leitendes Material abgeschieden, das eine für alle Kondensatoren der Speicherzellenanordnung gemeinsame zweite Kondensatorelektrode bildet.

Damit beim Vertiefen der zweiten Gräben die zweite leitende Schicht nicht angegriffen wird, ist es vorteilhaft, über der zweiten leitenden Schicht eine Hilfsschicht zu erzeugen. Beim Vertiefen wird selektiv zur Hilfsschicht geätzt.

Damit ein Potential an der zweiten Kondensatorelektrode zwischen quer zur Wortleitung zueinander benachbarten ersten Source/Drain-Gebieten keine Kanäle erzeugt, kann vor Erzeugung der zweiten Kondensatorelektrode oder der vertikalen leitenden Strukturen eine Implantation durchgeführt werden, wodurch mindestens an Böden der zweiten Gräben Channel-Stop-Strukturen in Form von weiteren Channel-Stop-Gebieten erzeugt werden, die höher dotiert sind als die Kanalgebiete. Alternativ werden die Channel-Stop-Strukturen aus isolierendem Material in Form von weiteren isolierenden Strukturen, die an die Böden der zweiten Gräben angrenzen, erzeugt, indem die zweiten Gräben besonders stark vertieft und z.B. durch Abscheiden und Rückätzen vom isolierenden Material teilweise gefüllt werden. Die Channel-Stop-Strukturen füllen die vertieften Teile der zweiten Gräben nicht vollständig auf, damit die vertikalen leitenden Strukturen die ersten Source/Drain-Gebiete kontaktieren können.

Ein zweites Source/Drain-Gebiet des Transistors kann unterhalb des Kanalgebiets oder zum Kanalgebiet diagonal nach unten versetzt, d.h. lateral zum und tiefer als das Kanalgebiet, angeordnet sein. Im ersten Fall können die ersten Gräben und/oder die zweiten Gräben eine Schichtenfolge entsprechend Source-, Kanal- und Drain-Gebiet strukturieren. Im zweiten Fall kann nach Erzeugung der ersten Gräben eine Implantation durchgeführt werden, wodurch an Böden der ersten Gräben das zweite Source/Drain-Gebiet entsteht. Ist die integrierte Schaltungsanordnung eine Speicherzellenanordnung, entstehen entlang der Böden der ersten Gräben Bitleitungen, die teilweise als zweite Source/Drain-Gebiete der Transistoren wirken.

Das Gebiet, aus dem die ersten Source/Drain-Gebiete erzeugt werden, kann z.B. ganzflächig erzeugt werden und anschließend durch die ersten Gräben streifenförmig strukturiert werden. Alternativ wird das Gebiet in Form von Streifen erzeugt, indem nach Erzeugung der ersten Gräben implantiert wird.

Die Speicherzellen können jeweils mit einer Fläche von 4*F*² erzeugt werden, wobei F die minimale, in der verwendeten Technologie herstellbare Strukturgröße ist.

Im folgenden werden Ausführungsbeispiele der Erfindung, die in den Figuren dargestellt sind, näher erläutert.
- Figur 1: zeigt einen Querschnitt durch ein erstes Substrat, nachdem eine Wanne, erste Gräben, ein Gebiet, Bitleitungen und Strukturen, die die Ausbildung von Kanälen verhindern, erzeugt wurden.
- Figur 2a: zeigt den Querschnitt aus Figur 1, nachdem eine erste isolierende Schicht, Wortleitungen, eine zweite isolierende Schicht, eine leitende Schicht, eine Hilfsschicht und zweite Gräben erzeugt wurden.
- Figur 2b: zeigt einen zum Querschnitt aus Figur 2a senkrechten Querschnitt durch das erste Substrat nach den Prozeßschritten aus Figur 2a.
- Figur 2c: zeigt einen zum Querschnitt aus Figur 2a parallelen Querschnitt durch das erste Substrat nach den Prozeßschritten aus Figur 2a.
- Figur 3a: zeigt den Querschnitt aus Figur 2a, nachdem isolierende Strukturen erzeugt wurden, die zweiten Gräben vertieft wurden, Channel-Stop-Strukturen, vertikale leitende Strukturen, ein Kondensatordielektrikum und eine zweite Kondensatorelektrode erzeugt wurden.
- Figur 3b: zeigt den Querschnitt aus Figur 2b nach den Prozeßschritten aus Figur 3a.
- Figur 4: zeigt eine Aufsicht auf das erste Substrat, in dem die ersten Gräben, die zweiten Gräben, eine erste Maske, eine zweite Maske und eine dritte Maske dargestellt sind.
- Figur 5: zeigt einen Querschnitt durch ein zweites Substrat, nachdem eine Wanne, erste Gräben, Bitleitungen, ein Gebiet und Strukturen, die die Ausbildung von Kanälen verhindern, erzeugt wurden.
- Figur 6: zeigt einen Querschnitt zum Querschnitt aus Figur 5 senkrechten Querschnitt durch das zweite Substrat, nachdem erste Source/Drain-Gebiete, eine erste isolierende Schicht, Wortleitungen, eine zweite isolierende Schicht, eine leitende Schicht, zweite Gräben, isolierende Strukturen und Channel-Stop-Strukturen erzeugt wurden.
- Figur 7: zeigt eine Aufsicht auf ein drittes Substrat, in der erste Gräben, zweite Gräben und eine Maske dargestellt sind.
- Figur 8: zeigt einen Querschnitt durch das dritte Substrat, nachdem eine Wanne, die ersten Gräben, Bitleitungen, ein Gebiet, Strukturen, die die Ausbildung von Kanälen verhindern, Vertiefungen und weitere isolierende Strukturen erzeugt wurden.

Die Figuren sind nicht maßstäblich.

In einem ersten Ausführungsbeispiel ist ein erstes Substrat 1, das Silizium enthält, vorgesehen, das eine an eine Oberfläche O des ersten Substrats 1 angrenzende ca. 600 nm tiefe p-dotierte Wanne WA umfaßt. Die Dotierstoffkonzentration der Wanne WA beträgt ca. 10¹⁷cm⁻³.

Mit Hilfe einer ersten Maske M1 aus Fotolack werden im wesentlichen parallel zueinander verlaufende ca. 200nm breite erste Gräben G1 erzeugt, die einen Abstand von ca. 200nm voneinander aufweisen. Die ersten Gräben G1 sind ca. 600nm tief.

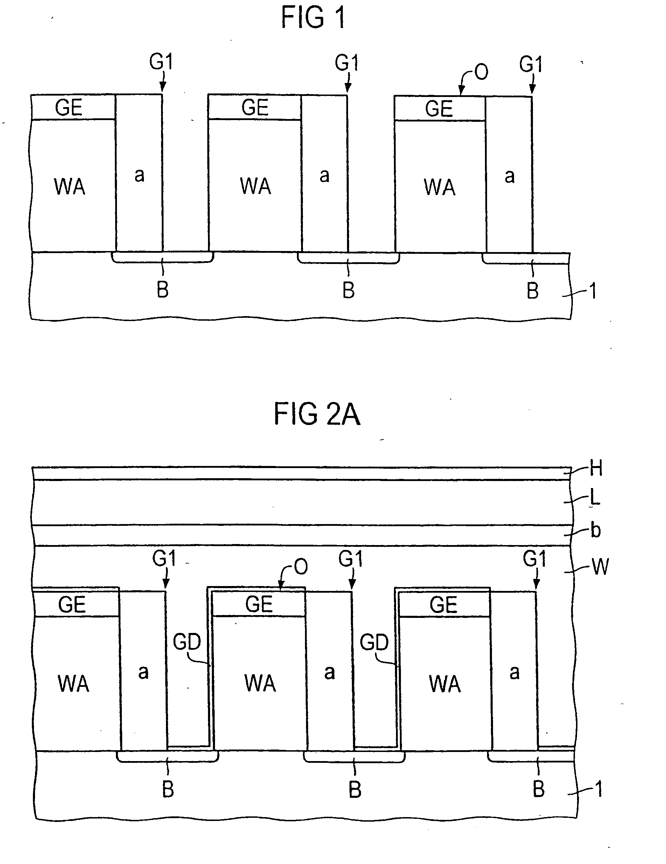

Durch Implantation werden entlang Böden der ersten Gräben G1 verlaufende n-dotierte Bitleitungen B und an der Oberfläche O ein ca. 50nm tiefes n-dotiertes Gebiet GE, das mehrere zwischen den Gräben G1 angeordnete Streifen umfaßt, erzeugt (siehe Figur 1). Die Dotierstoffkonzentration der Bitleitungen B und des dotierten Gebiets GE ist größer als ca. 10²⁰cm⁻³.

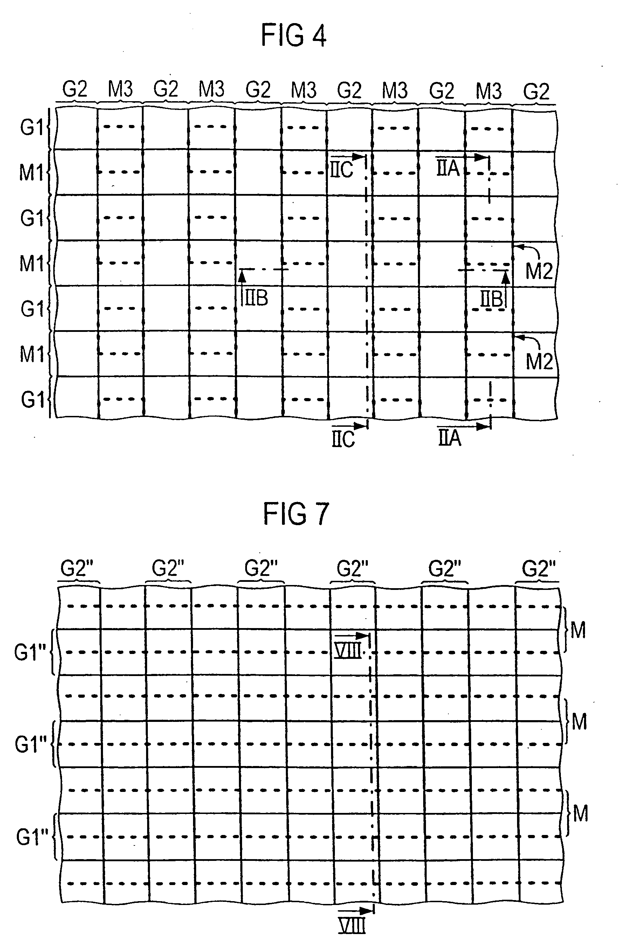

Anschließend wird SiO₂ in einer Dicke von ca. 600nm abgeschieden, wodurch die ersten Gräben G1 gefüllt werden. Durch chemisch mechanisches Polieren wird SiO₂ abgetragen und planarisiert, bis die Gebiete GE freigelegt werden. Mit Hilfe einer zweiten Maske M2 aus Fotolack, die rechteckige Bereiche nicht bedeckt, wird SiO₂ geätzt, bis die Bitleitungen B teilweise freigelegt werden. Dabei entstehen Strukturen a, die an erste Flanken der ersten Gräben G1 angrenzen und an Teilen von zweiten Flanken der ersten Gräben G1 nicht angrenzen (siehe Figur 1). Die rechteckigen Bereiche sind ca. 200nm breit und ca. 200nm lang und überlappen die ersten Flanken der ersten Gräben G1. Entlang der ersten Gräben G1 zueinander benachbarte rechteckige Bereiche weisen einen Abstand von ca. 200nm voneinander auf (siehe Figur 4). Die Strukturen a sind entlang der ersten Gräben G1 jeweils zusammenhängend ausgebildet.

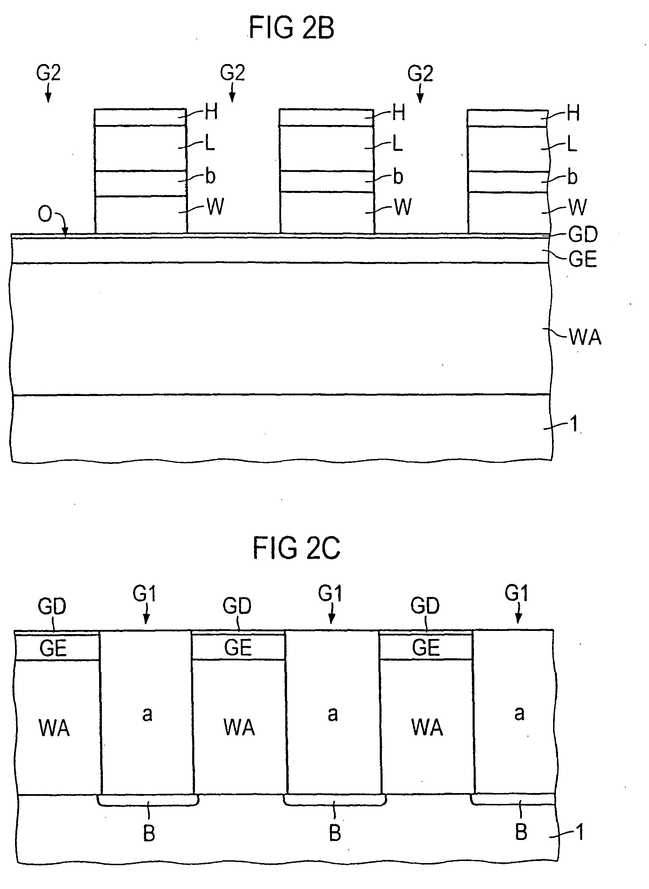

Zur Erzeugung einer ersten isolierenden Schicht GD wird eine thermische Oxidation durchgeführt (siehe Figur 2a). Da die Dotierstoffkonzentration der Bitleitungen B und des Gebiets GE höher ist als die der Wanne WA, ist die erste isolierende Schicht GD im Bereich der Wanne WA dünner als im Bereich der Gebiete GE und der Bitleitungen B. Dieser Sachverhalt ist in den Figuren nicht dargestellt.

Durch Abscheiden und Planarisieren von insitu dotiertem Polysilizium wird eine erste leitende Schicht erzeugt. Darüber wird durch Abscheiden von SiO₂ eine ca. 100nm dicke zweite isolierende Schicht b erzeugt. Darüber wird durch Abscheiden von insitu dotiertem Polysilizium eine ca. 400nm dicke zweite leitende Schicht L erzeugt. Darüber wird durch Abscheiden von Siliziumnitrid eine ca. 50nm dicke Hilfsschicht H erzeugt (siehe Figuren 2a und 2b).

Zur Erzeugung von quer zu den ersten Gräben G1 verlaufenden zweiten Gräben G2 werden mit Hilfe einer streifenförmigen dritten Maske M3 aus Fotolack die Hilfsschicht H, die zweite leitende Schicht L, die zweite isolierende Schicht b und die erste leitende Schicht geätzt, bis zwischen den ersten Gräben G1 angeordnete Teile der ersten isolierenden Schicht GD freigelegt werden. Die erste isolierende Schicht GD dient als Ätzstop. Dabei entstehen aus der ersten leitenden Schicht Wortleitungen W (siehe Figuren 2a und 2b).

Zur Erzeugung von isolierenden Strukturen c wird Siliziumnitrid konform in einer Dicke von ca. 20nm abgeschieden und rückgeätzt, bis die Hilfsschicht H freigelegt wird. An Flanken der zweiten Gräben G2 entstehen die isolierenden Strukturen c in Form von Spacern.

Anschließend werden durch Ätzen mit z.B. C₂F₆, C₃F₈ die auf der Oberfläche O des Substrats 1 angeordneten Teile der ersten isolierenden Schicht GD selektiv zur Hilfsschicht H und zu den isolierenden Strukturen c entfernt.

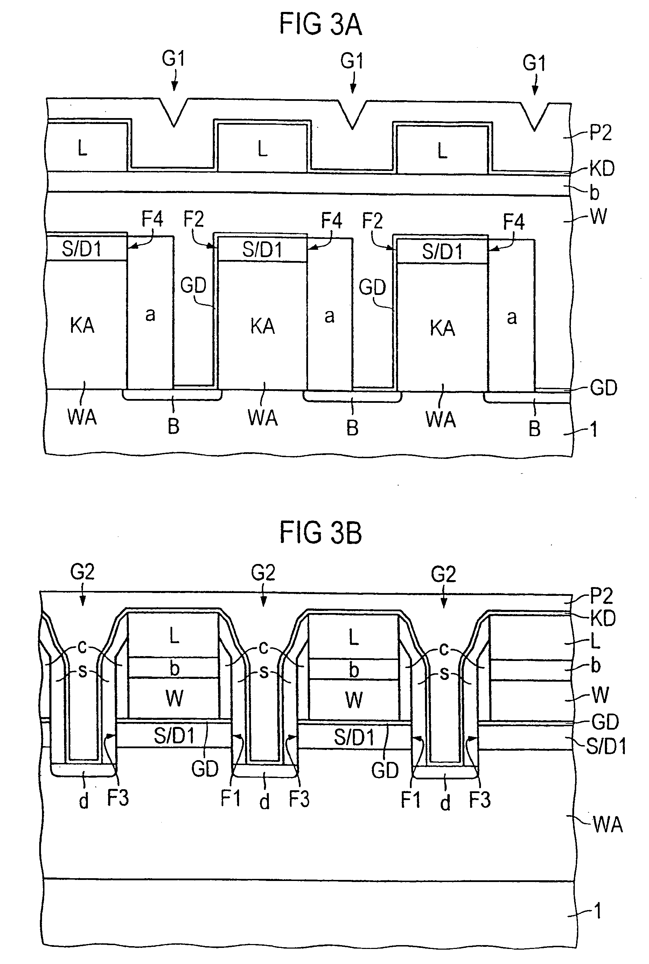

Durch Ätzen von Silizium selektiv zu Siliziumnitrid mit z.B. NF₃, HBr, He, O₂ werden die zweiten Gräben G2 vertieft, so daß sie das Gebiet GE durchtrennen. Dabei entstehen aus dem Gebiet GE erste Source/Drain-Gebiete S/D1 von vertikalen Transistoren. Die vertieften zweiten Gräben G2 reichen ca. 100 nm in das erste Substrat 1 hinein (siehe Figur 3b). Erste Flanken F1 der ersten Source/Drain-Gebiete S/D1 werden durch die zweiten Gräben G2 gebildet. Zweite Flanken F2 der ersten Source/Drain-Gebiete S/D1 grenzen an die ersten Flanken F1 der ersten Source/Drain-Gebiete S/D1 an. An den zweiten Flanken F2 der ersten Source/Drain-Gebiete S/D1 sind Teile der Wortleitungen W angeordnet. Dritte Flanken F3 der ersten Source/Drain-Gebiete S/D1 grenzen an die zweiten Flanken F2 der ersten Source/Drain-Gebiete S/D1 an, liegen den ersten Flanken F1 der ersten Source/Drain-Gebiete S/D1 gegenüber und werden durch die zweiten Gräben G2 gebildet. Vierte Flanken F4 der ersten Source/Drain-Gebiete S/D1 liegen den zweiten Flanken F2 der ersten Source/Drain-Gebiete S/D1 gegenüber. An den vierten Flanken F4 der ersten Source/Drain-Gebiete S/D1 sind die Strukturen a angeordnet.

Durch Implantation mit p-dotierenden Ionen werden an Böden der zweiten Gräben G2 Channel-Stop-Strukturen d in Form von Channel-Stop-Gebieten erzeugt (siehe Figur 3b).

Durch anisotropes Ätzen von Siliziumnitrid selektiv zu Silizium werden die spacerförmigen isolierenden Strukturen c in vertikaler Richtung verkleinert und die Hilfsschicht H entfernt, wodurch die zweite leitende Schicht L an ihrer oberen Oberfläche und teilweise an ihren Flanken freigelegt wird (siehe Figur 3b).

Durch Abscheiden und Rückätzen von insitu dotiertem Polysilizium werden entlang den Flanken der zweiten Gräben G2 vertikale leitende Strukturen S erzeugt, die an die zweite leitende Schicht L und an die spacerförmigen isolierenden Strukturen c angrenzen (siehe Figur 3b). Die vertikalen leitenden Strukturen S überlappen jeweils entweder eine der dritten Flanken F3 der ersten Source/Drain-Gebiete S/D1 oder eine der ersten Flanken F1 der ersten Source/Drain-Gebiete S/D1.

Mit Hilfe einer zur ersten Maske M1 analogen Maske wird Polysilizium selektiv zu SiO₂ geätzt, bis die zweite isolierende Schicht b freigelegt wird. Dadurch entstehen aus der zweiten leitenden Schicht L und aus den vertikalen leitenden Strukturen S voneinander getrennte erste Kondensatorelektroden P1 von Kondensatoren (siehe Figur 3a). Die vertikalen leitenden Strukturen S überlappen jeweils entweder eine erste Flanke von Teilen der strukturierten zweiten leitenden Schicht L oder eine der ersten Flanke gegenüberliegende Flanke der Teile der strukturierten zweiten leitenden Schicht L.

Zur Erzeugung eines Kondensatordielektrikums KD wird Siliziumnitrid in einer Dicke von ca. 5nm abgeschieden und teilweise aufoxidiert.

Zur Erzeugung einer zweiten Kondensatorelektrode P2 wird insitu dotiertes Polysilizium in einer Dicke von ca. 200nm abgeschieden, wodurch die zweiten Gräben G2 gefüllt werden (siehe Figuren 3a und 3b).

Unter den ersten Source/Drain-Gebieten S/D1 angeordnete Teile der Wanne WA sind als Kanalgebiete KA der vertikalen Transistoren geeignet. Die Wanne WA legt eine Einsatzspannung der vertikalen Transistoren fest. Teile der Wortleitungen W, die an die Kanalgebiete KA angrenzen, wirken als Gateelektroden der Transistoren. Teile der ersten isolierenden Schicht GD, die an die Gateelektroden angrenzen, wirken als Gatedielektrika. Unterhalb der Gateelektroden angeordnete Teile der Bitleitungen B wirken als zweite Source/Drain-Gebiete der Transistoren. Eine Speicherzelle umfaßt einen der Transistoren und einen der Kondensatoren, die über zwei der vertikalen leitenden Strukturen S miteinander verbunden sind. Die Strukturen a verhindern die Ausbildung von Kanälen an den ersten Flanken der ersten Gräben G1. Dadurch wird gewährleistet, daß zwei mit derselben Wortleitung W verbundene Transistoren nicht mit derselben Bitleitung B verbunden sind. Die an den Böden der zweiten Gräben G2 angeordneten Channel-Stop-Gebiete d verhindern die Ausbildung von Kanälen zwischen quer zur Wortleitung W zueinander benachbarte erste Source/Drain-Gebiete S/D1 verschiedener Transistoren (siehe Figur 3b).

In einem zweiten Ausführungsbeispiel werden analog wie im ersten Ausführungsbeispiel ein zweites Substrat 2 mit einer Wanne WA', erste Gräben G1', dotierte Gebiete GE' und Bitleitungen B' erzeugt.

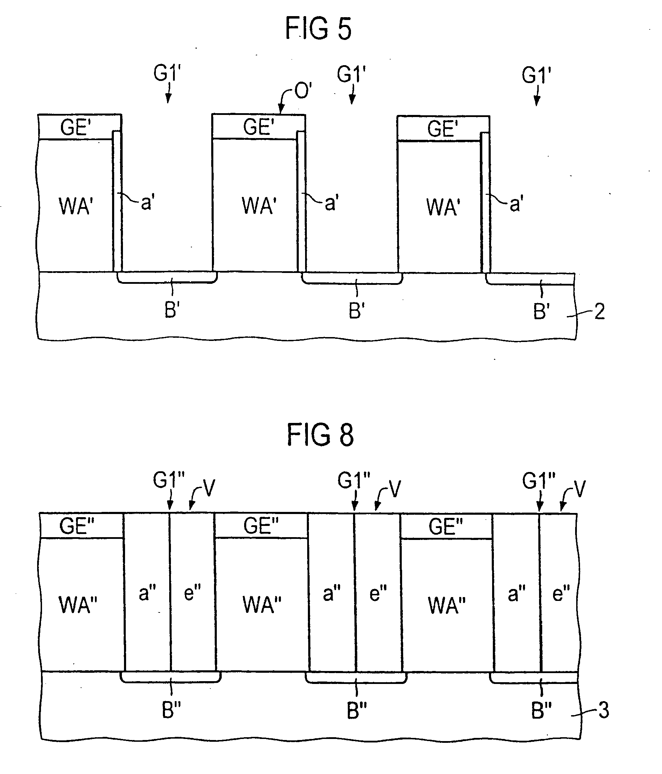

Durch schräge Implantation mit p-dotierenden Ionen werden an ersten Flanken der ersten Gräben G1' Strukturen a' in Form von Channel-Stop-Gebieten erzeugt. Die Dotierstoffkonzentration der Strukturen a' beträgt ca. 5*10¹⁷cm⁻³ (siehe Figur 5).

Anschließend werden analog wie im ersten Ausführungsbeispiel eine erste isolierende Schicht GD', aus einer ersten leitenden Schicht Wortleitungen W', eine zweite isolierende Schicht b', eine zweite leitende Schicht L', eine Hilfsschicht H', zweite Gräben G2', erste Source/Drain-Gebiete S/D1' und spacerförmige isolierende Strukturen c' erzeugt.

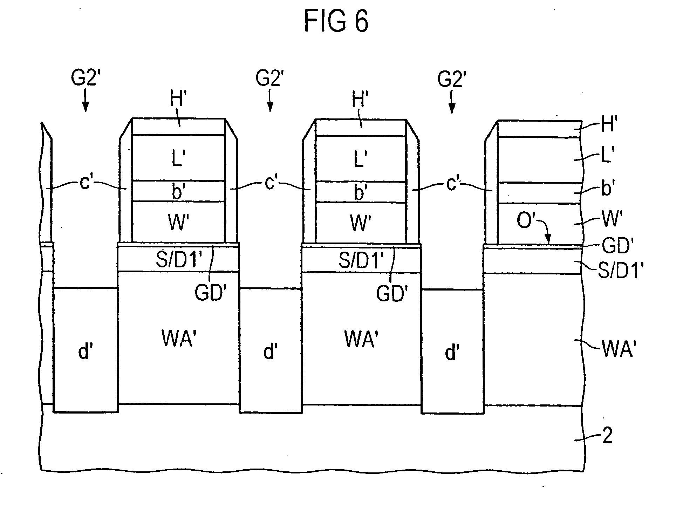

Nach Entfernen von Teilen der ersten isolierenden Schicht GD', die an einer Oberfläche O' des zweiten Substrats 2 angeordnet sind, wird Silizium selektiv zu Siliziumnitrid geätzt, wodurch die zweiten Gräben G2' vertieft werden und ca. 800nm in das zweite Substrat 2 hineinreichen. Die Wanne WA' wird dabei von den zweiten Gräben G2' durchtrennt (siehe Figur 6).

Durch Abscheiden von SiO₂ in einer Dicke von ca. 600nm und Rückätzen werden entlang Böden der zweiten Gräben G2' ca. 500nm dicke Channel-Stop-Strukturen d' erzeugt. Eine obere Fläche der Channel-Stop-Strukturen d' liegt unterhalb einer oberen Fläche der ersten Source/Drain-Gebiete S/D1', weshalb Teile von Flanken der ersten Source/Drain-Gebiete S/D1' frei liegen (siehe Figur 6).

Anschließend werden analog wie im ersten Ausführungsbeispiel die Hilfsschicht H' entfernt, die spacerförmigen isolierenden Strukturen c' verkürzt und vertikale leitende Strukturen, erste Kondensatorelektroden, ein Kondensatordielektrikum und eine zweite Kondensatorelektrode erzeugt. Die Channel-Stop-Strukturen d' verhindern die Ausbildung von Kanälen zwischen quer zur Wortleitung W' zueinander benachbarten ersten Source/Drain-Gebieten S/D1'. Aus den Figuren nicht ersichtlich ist, daß beim zweiten Ausführungsbeispiel vertikale Abmessungen der vertikalen leitenden Strukturen S' größer sind als jene des ersten Ausführungsbeispiels. Die Kapazität des Kondensators ist entsprechend größer als beim ersten Ausführungsbeispiel.

In einem dritten Ausführungsbeispiel ist wie im ersten Ausführungsbeispiel ein drittes Substrat 3 aus Silizium mit einer Wanne WA" vorgesehen. Wie im ersten Ausführungsbeispiel werden erste Gräben G1" , Bitleitungen B'' und ein dotiertes Gebiet GE" erzeugt. Wie im ersten Ausführungsbeispiel wird isolierendes Material abgeschieden und planarisiert, wodurch die ersten Gräben G1" mit isolierendem Material gefüllt werden.

Mit Hilfe einer streifenförmigen Fotolackmaske M, deren Streifen parallel zu den ersten Gräben G1" verlaufen und erste Flanken der ersten Gräben G1" bedecken, wird das isolierende Material an den zweiten Flanken der ersten Gräben G1" entfernt (siehe Figur 7).

Wie im ersten Ausführungsbeispiel werden eine erste isolierende Schicht, eine erste leitende Schicht, eine zweite isolierende Schicht, eine zweite leitende Schicht, eine Hilfsschicht und zweite Gräben G2" erzeugt, wodurch aus der ersten leitenden Schicht Wortleitungen entstehen. Da die erste leitende Schicht im Gegensatz zum ersten Ausführungsbeispiel entlang der gesamten horizontalen Länge der zweiten Flanken der ersten Gräben G1" angeordnet ist, weisen die zweiten Gräben G2" in Gebieten, in denen sie die ersten Gräben G1" kreuzen, bis an die Böden der ersten Gräben G1" reichende Vertiefungen V mit rechteckigen Querschnitten auf (siehe Figur 8). Um diese Vertiefungen V wieder aufzufüllen, wird SiO₂ in einer Dicke von ca. 400nm abgeschieden und rückgeätzt, bis das dotierte Gebiet GE " freigelegt wird, wobei auf dem dotierten Gebiet GE " angeordnete Teile der ersten isolierenden Schicht entfernt werden. In den Vertiefungen V entstehen weitere isolierende Strukturen e" (siehe Figur 8).

Anschließend werden analog wie im ersten Ausführungsbeispiel spacerförmige isolierende Strukturen, vertikale leitende Strukturen, erste Kondensatorelektroden, Kondensatordielektrikum und eine zweite Kondensatorelektrode erzeugt. Da die auf dem dotierten Gebiet GE " angeordneten Teile der ersten isolierenden Schicht bei der Erzeugung der weiteren isolierenden Strukturen e" entfernt wurden, entfällt im dritten Ausführungsbeispiel der in den ersten beiden Ausführungsbeispielen erforderliche Schritt der Entfernung dieser Teile der ersten isolierenden Schicht nach Erzeugung der spacerförmigen isolierenden Strukturen.

Es sind viele Variationen der Ausführungsbeispiele denkbar, die ebenfalls im Rahmen der Erfindung liegen. Insbesondere können die Abmessungen der beschriebenen Schichten, Gräben, Masken, Gebiete, Leitungen und Strukturen nach Belieben an die jeweiligen Erfordernisse angepaßt werden. Dasselbe gilt auch für die vorgeschlagenen Dotierstoffkonzentrationen. Leitfähigkeitstypen der Schichten, Gebiete und Wannen können vertauscht werden.

Merkmale der drei Ausführungsbeispiele können miteinander kombiniert werden. Die als Channel-Stop-Gebiete ausgebildeten Strukturen a' des zweiten Ausführungsbeispiels, die die Ausbildung von Kanälen verhindern, können mit den vergleichsweise flachen zweiten Gräben G2 des ersten Ausführungsbeispiels kombiniert werden. Die aus isolierendem Material gebildeten Strukturen a des ersten Ausführungsbeispiels, die die Ausbildung von Kanälen verhindern, können mit den vergleichsweise tiefen zweiten Gräben G2' des zweiten Ausführungsbeispiels kombiniert werden. Die streifenförmige Fotolackmaske M des dritten Ausführungsbeispiels, die der Entfernung des isolierenden Materials von den zweiten Flanken der ersten Gräben G1" dient, kann auch für das erste Ausführungsbeispiel verwendet werden, falls tiefe statt flache zweite Gräben vorgesehen sind. In diesem Fall sind die Querschnitte von Vertiefungen, die bei der Erzeugung der Wortleitungen W entstehen, größer als beim dritten Ausführungsbeispiel, weil die Strukturen a, die die Ausbildung von Kanälen verhindern, nicht aus isolierendem Material bestehen und nicht Teile der ersten Gräben G1 füllen, sondern Channel-Stop-Gebiete sind.

## Patentansprüche

1. Integrierte Schaltungsanordnung mit mindestens einem Transistor und einem Kondensator,
- bei der eine Struktur, über die der Transistor ansteuerbar ist, und eine strukturierte leitende Schicht (L) übereinander angeordnet sind, wobei eine isolierende Schicht (b) die Struktur, über die der Transistor ansteuerbar ist, von der leitenden Schicht (L) trennt,
- bei der eine vertikale leitende Struktur vorhanden ist, die einen ersten Bereich, einen zweiten Bereich und einen dritten Bereich aufweist, die bezüglich einer vertikalen Achse übereinander angeordnet sind, wobei der zweite Bereich zwischen dem ersten Bereich und dem dritten Bereich angeordnet ist,
- bei der der erste Bereich der vertikalen leitenden Struktur (S) seitlich an die leitende Schicht (L) angrenzt,
- bei der eine isolierende Struktur (c) seitlich an die Struktur, über die der Transistor ansteuerbar ist, angrenzt,
- bei der der zweite Bereich der vertikalen leitenden Struktur (S) seitlich an die isolierende Struktur (c) angrenzt,
- bei der der dritte Bereich der vertikalen leitenden Struktur (S) an ein erstes Source/Drain-Gebiet (S/D1) des Transistors angrenzt,
- bei der die leitende Schicht (L) und die vertikale leitende Struktur (S) zusammen eine erste Kondensatorelektrode des Kondensators bilden,
- bei der ein Kondensatordielektrikum (KD) an die vertikale leitende Struktur (S) und an die leitende Schicht (L) angrenzt,
- bei der eine zweite Kondensatorelektrode (P2) des Kondensators an das Kondensatordielektrikum (KD) angrenzt,
**dadurch gekennzeichnet, dass**
- die Struktur, über die der Transistor ansteuerbar ist, zwischen dem ersten Source/Drain-Gebiet (S/D1) und der leitenden Schicht (L) angeordnet ist, wobei eine weitere isolierende Schicht (GD) die Struktur, über die der Transistor ansteuerbar ist, von dem ersten Source/Drain-Gebiet (S/D1) trennt, und die vertikale leitende Struktur (S) eine erste Flanke (F1) des ersten Source/Drain-Gebiets (S/D1) und eine erste Flanke der leitenden Schicht (L) überlappt.

2. Schaltungsanordnung nach Anspruch 1,
- bei der die vertikale leitende Struktur (S) spacerförmig ist.

3. Schaltungsanordnung nach Anspruch 1,
- bei der der Transistor als vertikaler Transistor ausgebildet ist und unter der leitenden Schicht (L) angeordnet ist,
- bei der unter dem ersten Source/Drain-Gebiet (S/D1) ein Kanalgebiet (KA) des Transistors angeordnet ist,
- bei der eine Gateelektrode des Transistors an einer durch das Kanalgebiet (KA) gebildeten Fortsetzung einer an die erste Flanke (F1) des ersten Source/Drain-Gebiets (S/D1) angrenzenden zweiten Flanke (F2) des ersten Source/Drain-Gebiets (S/D1) angeordnet ist, die mit einem Gatedielektrikum versehen ist
- bei der die Gateelektrode mit der Struktur, über die der Transistor ansteuerbar ist, verbunden ist,
- bei der die zweite Flanke (F2) des ersten Source/Drain-Gebiets (S/D1) mit einer Isolation versehenen ist, die die Gateelektrode vom ersten Source/Drain-Gebiet (S/D1) elektrisch isoliert.

4. Schaltungsanordnung nach Anspruch 1 bis 3,
- die eine DRAM-Zellenanordnung ist,
- bei der eine Speicherzelle den Transistor und den Kondenstor umfaßt,
- bei der die Struktur, über die der Transistor ansteuerbar ist, eine Wortleitung (W) ist, die parallel zur ersten Flanke (F1) des ersten Source/Drain-Gebiets (S/D1) verläuft,
- bei der ein zweites Source/Drain-Gebiet des Transistors mit einer Bitleitung (B) verbunden ist.

5. Schaltungsanordnung nach Anspruch 4,
- bei der erste Gräben (G1) quer zur Wortleitung (W) verlaufen, zwischen denen erste Source/Drain-Gebiete (S/D1) von Transistoren angeordnet sind,
- bei der Strukturen (a), die die Ausbildung von Kanälen verhindern, an erste Flanken der ersten Gräben (G1) angrenzen,
- bei der Gateelektroden der Transistoren an mit einem Gatedielektrikum versehene zweite Flanken der ersten Gräben (G1) angrenzen.

6. Schaltungsanordnung nach Anspruch 4 oder 5,
- bei der quer zur Wortleitung (W) zueinander benachbarte erste Source/Drain-Gebiete (S/D1) durch zweite Gräben (G2), die parallel und zwischen den Wortleitungen (W) verlaufen, voneinander getrennt sind,
- bei der quer zur Wortleitung (W) zueinander benachbarte Kanalgebiete (KA) der Transistoren zusammenhängen,
- bei der Böden der zweiten Gräben (G2) mit als Channel-Stop-Gebiete ausgebildete Channel-Stop-Strukturen (d), die die Ausbildung von Kanälen verhindern, versehen sind,
- bei der die vertikale leitende Struktur (S) in einem der zweiten Gräben (G2) angeordnet ist.

7. Schaltungsanordnung nach Anspruch 4 oder 5,
- bei der quer zur Wortleitung (W') zueinander benachbarte erste Source/Drain-Gebiete (S/D1') durch zweite Gräben (G2'), die parallel und zwischen den Wortleitungen (W') verlaufen, voneinander getrennt sind,
- bei der isolierendes Material enthaltende Channel-Stop-Strukturen (d'), die die Ausbildung von Kanälen verhindern, in den zweiten Gräben (G2') angeordnet sind und an Böden der zweiten Gräben (G2') angrenzen,
- bei der die vertikale leitende Struktur (S) in einem der zweiten Gräben (G2') angeordnet ist.

8. Schaltungsanordnung nach einem der Ansprüche 5 bis 7,
- bei der zweite Source/Drain-Gebiete Teile der Bitleitungen (B) sind, die entlang Böden der ersten Gräben (G1) verlaufen.

9. Verfahren zur Herstellung einer integrierten Schaltungsanordnung mit mindestens einem Transistor und einem Kondensator,
- bei dem an einer Oberfläche (O) eines Substrats (1) ein leitendes Gebiet (GE) erzeugt wird,
- bei dem mindestens eine erste isolierende Schicht (GD), darüber eine erste leitende Schicht, darüber eine zweite isolierende Schicht (b) und darüber eine zweite leitende Schicht (L) abgeschieden werden,
- bei dem eine Vertiefung erzeugt wird, die mindestens die erste leitende Schicht durchtrennt,
- bei dem ein isolierendes Material abgeschieden und so weit rückgeätzt wird, daß eine spacerförmige isolierende Struktur (c) entsteht, die die erste leitende Schicht seitlich bedeckt,
- bei dem die Vertiefung vertieft wird, so daß das Gebiet (GE) durchtrennt wird, wobei selektiv zur isolierenden Struktur (c) geätzt wird,
- bei dem durch Abscheiden und Rückätzen von leitendem Material eine spacerförmige vertikale leitende Struktur (S) erzeugt wird, die das Gebiet (GE), die isolierende Struktur (c) und die zweite leitende Schicht (L) überlappt und an die zweite leitende Schicht (L) angrenzt,
- bei dem aus der zweiten leitenden Schicht (L) und der vertikalen leitenden Struktur (S) eine erste Kondensatorelektrode des Kondensators, aus der ersten leitenden Schicht eine Struktur, über die der Transistor ansteuerbar ist, und aus dem Gebiet (GE) ein erstes Source/Drain-Gebiet (S/D1) des Transistors erzeugt werden,
- bei dem angrenzend an die zweite leitende Schicht (L) und an der vertikalen leitenden Struktur (S) ein Kondensatordielektrikum (KD) und daran angrenzend eine zweite Kondensatorelektrode (P2) erzeugt werden.

10. Verfahren nach Anspruch 9,
- bei dem Speicherzellen erzeugt werden,
- bei dem der Transistor und der Kondensator als Teile einer der Speicherzellen erzeugt werden,
- bei dem im Substrat (1) vor Erzeugung der ersten isolierenden Schicht (GD) im wesentlichen parallel zueinander verlaufende erste Gräben (G1) erzeugt werden,
- bei dem erste Flanken der ersten Gräben (G1) mit Strukturen (a), die die Ausbildung von Kanälen verhindern, versehen werden,
- bei dem ein Gatedielektrikum, das zweite Flanken der ersten Gräben (G1) teilweise bedeckt, und die erste isolierende Schicht (GD) erzeugt werden,
- bei dem zur Erzeugung der ersten leitenden Schicht leitendes Material abgeschieden und planarisiert wird, wobei die ersten Gräben (G1) auffüllt werden und die mit der ersten isolierenden Schicht (GD) versehene Oberfläche (O) des Substrats (1) von der ersten leitenden Schicht bedeckt wird,
- bei dem die Vertiefung als Teil eines von quer zu den ersten Gräben (G1) verlaufenden zweiten Gräben (G2) erzeugt wird, wobei aus der ersten leitenden Schicht Wortleitungen (W) erzeugt werden,
- bei dem an zweiten Flanken der ersten Gräben (G1) vertikale Transistoren der Speicherzellen erzeugt werden, wobei Teile der Wortleitungen (W), die an die zweiten Flanken der ersten Gräben (G1) angrenzen, als Gateelektroden der Transistoren dienen,
- bei dem aus dem Gebiet (GE) erste Source/Drain-Gebiete (S/D1) der Transistoren erzeugt werden, die durch die ersten Gräben (G1) und die zweiten Gräben (G2) voneinander getrennt sind.

11. Verfahren nach Anspruch 10,
- bei dem die Strukturen (a'), die die Ausbildung von Kanälen verhindern, durch schräge Implantation in Form von Channel-Stop-Gebieten erzeugt werden.

12. Verfahren nach Anspruch 10,
- bei dem zur Erzeugung der Strukturen (a), die die Ausbildung von Kanälen verhindern, isolierendes Material abgeschieden wird, wodurch die ersten Gräben (G1) gefüllt werden,
- bei dem das isolierende Material durch ein fotolithographisches Verfahren mindestens von Teilen der zweiten Flanken der ersten Gräben (G1) entfernt wird, und dabei aus dem isolierenden Material die Strukturen (a), die die Ausbildung von Kanälen verhindern, erzeugt werden.

13. Verfahren nach einem der Ansprüche 9, bis 12,
- bei dem nach Erzeugung der ersten Gräben (G1) eine Implantation durchgeführt wird, wodurch an Böden der ersten Gräben (G1) Bitleitungen (B), die teilweise als zweite Source/Drain-Gebiete der Transistoren wirken, und das Gebiet (GE) in Form von Streifen an der Oberfläche (O) des Substrats (1) erzeugt werden.

## Claims

1. Integrated circuit arrangement having at least one transistor and one capacitor
- in which a structure via which the transistor can be driven and a patterned conductive layer (L) are arranged one above the other, an insulating layer (b) isolating the structure via which the transistor can be driven from the conductive layer (L),
- in which a vertical conductive structure is present, which has a first region, a second region and a third region which are arranged one above the other with respect to a vertical axis, the second region being arranged between the first region and the third region,
- in which the first region of the vertical conductive structure (S) laterally adjoins the conductive layer (L),
- in which an insulating structure (c) laterally adjoins the structure via which the transistor can be driven,
- in which the second region of the vertical conductive structure (S) laterally adjoins the insulating structure (c),
- in which the third region of the vertical conductive structure (S) adjoins a first source/drain region (S/D1) of the transistor,
- in which the conductive layer (L) and the vertical conductive structure (S) together form a first capacitor electrode of the capacitor,
- in which a capacitor dielectric (KD) adjoins the vertical conductive structure (S) and the conductive layer (L),
- in which a second capacitor electrode (P2) of the capacitor adjoins the capacitor dielectric (KD),
**characterized in that**
- the structure via which the transistor can be driven is arranged between the first source/drain region (S/D1) and the conductive layer (L), a further insulating layer (GD) isolating the structure via which the transistor can be driven from the first source/drain region (S/D1), and the vertical conductive structure (S) overlaps a first sidewall (F1) of the first source/drain region (S/D1) and a first sidewall of the conductive layer (L).

2. Circuit arrangement according to Claim 1,
- in which the vertical conductive structure (S) is in the form of a spacer.

3. Circuit arrangement according to Claim 1,
- in which the transistor is designed as a vertical transistor and is arranged under the conductive layer (L),
- in which a channel region (KA) of the transistor is arranged under the first source/drain region (S/D1),
- in which a gate electrode of the transistor is arranged on a continuation - formed by the channel region (KA) - of a second sidewall (F2) of the first source/drain region (S/D1), said second sidewall adjoining the first sidewall (F1) of the first source/drain region (S/D1), which is provided with a gate dielectric,
- in which the gate electrode is connected to the structure via which the transistor can be driven,
- in which the second sidewall (F2) of the first source/drain region (S/D1) is provided with insulation which electrically insulates the gate electrode from the first source/drain region (S/D1).

4. Circuit arrangement according to Claims 1 to 3,
- which is a DRAM cell arrangement,
- in which a memory cell comprises the transistor and the capacitor,
- in which the structure via which the transistor can be driven is a word line (W) running parallel to the first sidewall (F1) of the first source/drain region (S/D1),
- in which a second source/drain region of the transistor is connected to a bit line (B).

5. Circuit arrangement according to Claim 4,
- in which first trenches (G1) run transversely with respect to the word line (W), first source/drain regions (S/D1) of transistors being arranged between them,
- in which structures (a) which prevent the formation of channels adjoin first sidewalls of the first trenches (G1),
- in which gate electrodes of the transistors adjoin second sidewalls of the first trenches (G1), said second sidewalls being provided with a gate dielectric.

6. Circuit arrangement according to Claim 4 or 5,
- in which first source/drain regions (S/D1) which are adjacent to one another transversely with respect to the word line (W) are isolated from one another by second trenches (G2) running parallel and between the word lines (W),
- in which channel regions (KA) of the transistors which are adjacent to one another transversely with respect to the word line (W) are contiguous,
- in which bottoms of the second trenches (G2) are provided with channel stop structures (d), which are designed as channel stop regions and prevent the formation of channels,
- in which the vertical conductive structure (S) is arranged in one of the second trenches (G2).

7. Circuit arrangement according to Claim 4 or 5,
- in which first source/drain regions (S/D1') which are adjacent to one another transversely with respect to the word line (W') are isolated from one another by second trenches (G2') running parallel and between the word lines (W'),
- in which channel stop structures (d') which contain insulating material and prevent the formation of channels are arranged in the second trenches (G2') and adjoin bottoms of the second trenches (G2'),
- in which the vertical conductive structure (S) is arranged in one of the second trenches (G2').

8. Circuit arrangement according to one of Claims 5 to 7,
- in which second source/drain regions are parts of the bit lines (B) which run along bottoms of the first trenches (G1).

9. Method for fabricating an integrated circuit arrangement having at least one transistor and one capacitor,
- in which a conductive region (GE) is produced at a surface (O) of a substrate (1),
- in which at least one first insulating layer (GD) is deposited, over the latter a first conductive layer is deposited, over the latter a second insulating layer (b) is deposited, and over the latter a second conductive layer (L) is deposited,
- in which a depression is produced, which cuts through at least the first conductive layer,
- in which an insulating material is deposited and etched back to an extent such that an insulating structure (c) in the form of a spacer is produced, which laterally covers the first conductive layer,
- in which the depression is deepened, so that the region (GE) is cut through, etching being effected selectively with respect to the insulating structure (c),
- in which a vertical conductive structure (S) in the form of a spacer is produced by depositing and etching back conductive material, which structure overlaps the region (GE), the insulating structure (c) and the second conductive layer (L) and adjoins the second conductive layer (L),
- in which a first capacitor electrode of the capacitor is produced from the second conductive layer (L) and the vertical conductive structure (S), a structure via which the transistor can be driven is produced from the first conductive layer, and a first source/drain region (S/D1) of the transistor is produced from the region (GE),
- in which a capacitor dielectric (KD) is produced in a manner adjoining the second conductive layer (L) and the vertical conductive structure (S), and a second capacitor electrode (P2) is produced in a manner adjoining said capacitor dielectric.

10. Method according to Claim 9,
- in which memory cells are produced,
- in which the transistor and the capacitor are produced as parts of one of the memory cells,
- in which first trenches (G1) essentially running parallel to one another are produced in the substrate (1) before the production of the first insulating layer (GD),
- in which first sidewalls of the first trenches (G1) are provided with structures (a) which prevent the formation of channels,
- in which a gate dielectric, which partly covers second sidewalls of the first trenches (G1), and the first insulating layer (GD) are produced,
- in which, in order to produce the first conductive layer, conductive material is deposited and planarized, the first trenches (G1) being filled and that surface (O) of the substrate (1) which is provided with the first insulating layer (GD) being covered by the first conductive layer,
- in which the depression is produced as part of one of second trenches (G2) running transversely with respect to the first trenches (G1), word lines (W) being produced from the first conductive layer,
- in which vertical transistors of the memory cells are produced on second sidewalls of the first trenches (G1), parts of the word lines (W) which adjoin the second sidewalls of the first trenches (G1) serving as gate electrodes of the transistors,
- in which first source/drain regions (S/D1) of the transistors are produced from the region (GE), which are isolated from one another by the first trenches (G1) and the second trenches (G2).

11. Method according to Claim 10,
- in which the structures (a') which prevent the formation of channels are produced by inclined implantation in the form of channel stop regions.

12. Method according to Claim 10,
- in which, in order to produce the structures (a) which prevent the formation of channels, insulating material is deposited, thereby filling the first trenches (G1),
- in which the insulating material is removed at least from parts of the second sidewalls of the first trenches (G1) by means of a photolithographic method, and the structures (a) which prevent the formation of channels are produced from the insulating material in the process.

13. Method according to one of Claims 9 to 12,
- in which, after the production of the first trenches (G1), an implantation is carried out, thereby producing bit lines (B) at bottoms of the first trenches (G1), said bit lines partly acting as second source/drain regions of the transistors, and the region (GE) in the form of strips at the surface (O) of the substrate (1).

## Revendications

1. Circuit intégré ayant au moins un transistor et un condensateur,
- dans lequel une structure, par laquelle le transistor peut être commandé, et une couche (L) conductrice structurée sont superposées, une couche (b) isolante séparant la couche (L) conductrice de la structure par laquelle le transistor peut être commandé,
- dans lequel il y a une structure conductrice verticale qui a une première partie, une deuxième partie et une troisième partie superposées par rapport à un axe vertical, la deuxième partie étant disposée entre la première partie et la troisième partie,
- dans lequel la première partie de la structure (S) conductrice verticale est voisine latéralement de la couche (L) conductrice,
- dans lequel une structure (c) isolante est voisine latéralement de la structure par laquelle le transistor peut être commandé,
- dans lequel la deuxième partie de la structure (S) conductrice verticale est voisine latéralement de la structure (c) isolante,
- dans lequel la troisième partie de la structure (S) conductrice verticale est voisine d'une première zone (S/D1) de source/drain du transistor,
- dans lequel la couche (L) conductrice et la structure (S) conductrice verticale forment ensemble une première électrode du condensateur,
- dans lequel un diélectrique (KD) de condensateur est voisin de la structure (S) conductrice verticale et de la couche (L) conductrice,
- dans lequel une deuxième électrode (P2) du condensateur est voisine du diélectrique (KD) du condensateur,
**caractérisé en ce que**
- la structure par laquelle le transistor peut être commandé est disposée entre la première zone (S/D1) de source/drain et la couche (L) conductrice, une autre couche (GD) isolante séparant la structure par laquelle le transistor peut être commandé de la première zone (S/D1) de source/drain, et la structure (S) conductrice verticale chevauche un premier flanc (F1) de la première zone (S/D1) de source/drain et un premier flanc de la couche (L) conductrice.

2. Circuit suivant la revendication,
- dans lequel la structure (S) conductrice verticale est en forme d'espaceur.

3. Circuit suivant la revendication 1,
- dans lequel le transistor est sous la forme d'un transistor vertical et est disposé sous la couche (L) conductrice,
- dans lequel une zone (KA) de canal du transistor est disposée sous la première zone (S/D1) de source/drain,
- dans lequel une électrode de grille du transistor est disposée sur un prolongement, tourné par la zone (KA) de canal, d'un deuxième flanc (F2) de la première zone (S/D1) de source/drain, qui est voisin du premier flanc (F1) de la première zone (S/D1) de source/drain et qui est muni d'un diélectrique de grille,
- dans lequel l'électrode de grille est reliée à la structure par laquelle le transistor peut être commandé,
- dans lequel le deuxième flanc (F2) de la première zone (S/D1) de source/drain est muni d'un isolant qui isole, du point de vue électrique, l'électrode de grille de la première zone (S/D1) de source/drain.

4. Circuit suivant la revendication 1 à 3,
- qui est un dispositif de cellules DRAM,
- dans lequel une cellule de mémoire comprend le transistor et le condensateur,
- dans lequel la structure par laquelle le transistor peut être commandé est une ligne (W) de mots qui s'étend parallèlement au premier flanc (F1) de la première zone (S/D1) de source/drain,
- dans lequel une deuxième zone de source/drain du transistor est reliée à une ligne (B) de bits.

5. Circuit suivant la revendication 4,
- dans lequel des premiers sillons (G1) s'étendent transversalement à la ligne (W) de mots, des premières zones (S/D1) de source/drain de transistor étant disposées entre eux,
- dans lequel des structures (a) qui empêchent la formation de canaux sont voisines de premiers flancs des premiers sillons (G1),
- dans lequel les électrodes de grille des transistors sont voisines de deuxièmes flancs des premiers sillons (G1), flancs qui sont munis d'un diélectrique de grille.

6. Circuit suivant la revendication 4 ou 5,
- dans lequel des premières zones (S/D1) de source/drain voisines les unes des autres transversalement à la ligne (W) de mots sont séparées les unes des autres par des deuxièmes sillons (G2) qui s'étendent parallèlement et entre les lignes (W) de mots,
- dans lequel des zones (KA) de canal de transistor voisines les unes des autres transversalement à la ligne (W) de mots sont d'un seul tenant,
- dans lequel des fonds des deuxièmes sillons (G2) sont munis de structures (d) d'arrêt de canal constituées en zones d'arrêt de canal et empêchant la formation de canaux,
- dans lequel la structure (S) conductrice verticale est disposée dans l'un des deuxièmes sillons (G2).

7. Circuit suivant la revendication 4 ou 5,
- dans lequel des premières zones (S/D1') de source/drain voisines les unes des autres transversalement à la ligne (W') de mots sont séparées les unes des autres par des deuxièmes sillons (G2') qui s'étendent parallèlement et entre les lignes (W') de mots,
- dans lequel des structures (d') d'arrêt de canal, qui contiennent du matériau isolant et qui empêchent la formation de canaux, sont disposées dans les deuxièmes sillons (G2') et sont voisines des fonds des deuxièmes sillons (G2'),
- dans lequel la structure (S) conductrice verticale est disposée dans l'un des deuxièmes sillons (G2').

8. Circuit suivant l'une des revendications 5 à 7,
- dans lequel des deuxièmes zones de source/drain font parties des lignes (B) de bits qui s'étendent le long des fonds des premiers sillons (G1).

9. Procédé de production d'un circuit intégré ayant au moins un transistor et un condensateur,
- dans lequel on produit sur une surface (O) d'un substrat (1) une zone (GE) conductrice,
- dans lequel on dépose au moins une première couche (GD) isolante au-dessus d'une première couche conductrice, au-dessus d'une deuxième couche (b) isolante et au-dessus d'une deuxième couche (L) conductrice,
- dans lequel on produit une cavité qui traverse au moins la première couche conductrice,
- dans lequel on dépose un matériau isolant et on l'attaque en retrait si loin qu'il se forme une structure (c) isolante en forme d'espaceur qui recouvre latéralement la première couche conductrice,
- dans lequel on approfondit la cavité, de manière à ce que la zone (GE) soit traversée en attaquant sélectivement par rapport à la structure (c) isolante,
- dans lequel on produit, par dépôt et attaque en retrait de matériau conducteur, une structure (S) conductrice verticale en forme d'espaceur, qui chevauche la zone (GE), la structure (c) isolante et la deuxième couche (L) conductrice et qui est voisine de la deuxième couche (L) conductrice,
- dans lequel on produit, à partir de la deuxième couche (L) conductrice et de la structure (S) conductrice verticale, une première électrode du condensateur, à partir de la première couche conductrice, une structure par laquelle le transistor peut être commandé et à partir de la zone (GE), une première zone (S/D1) de source/drain du transistor,
- dans lequel on produit, au voisinage de la deuxième couche (L) conductrice et de la structure (S) conductrice verticale, un diélectrique (KD) de condensateur et, au voisinage de celui-ci, une deuxième électrode (P2) de condensateur.

10. Procédé suivant la revendication 9,
- dans lequel on produit des cellules de mémoire,
- dans lequel on produit le transistor et le condensateur en tant que partie de l'une des cellules de mémoire,
- dans lequel on produit, dans le substrat (1), avant la production de la première couche (GD) isolante, des premiers sillons (G1) s'étendant en étant sensiblement parallèles les uns aux autres,
- dans lequel on munit les premiers flancs des premiers sillons (G1) de structures (a) qui empêchent la formation de canaux,
- dans lequel on produit un diélectrique de grille qui recouvre en partie des deuxièmes flancs des premiers sillons (G1), et la première couche (GD) isolante,
- dans lequel, pour la production de la première couche conductrice, on dépose et on planarise du matériau conducteur, on remplit les premiers sillons (G1) et on recouvre de la première couche conductrice la surface (O) du substrat (1) munie de la première couche (GD) isolante,
- dans lequel on produit la cavité sous la forme d'une partie d'un deuxième sillon (G2) s'étendant transversalement au premier sillon (G1), des lignes (W) de mots étant produites à partir de la première couche conductrice,
- dans lequel on produit, sur des deuxièmes flancs des premiers sillons (G1), des transistors verticaux des cellules de mémoire, des parties des lignes (W) de mots, qui sont voisines des deux flancs des premiers sillons (G1), servant d'électrodes de grille des transistors,
- dans lequel on produit, à partir de la zone (GE), des premières zones (S/D1) de source/drain des transistors qui sont séparées les unes des autres par les premiers sillons (G1) et par les deuxièmes sillons (G2).

11. Procédé suivant la revendication 10,
- dans lequel on produit les structures (a') qui empêchent la formation de canaux par une implantation inclinée sous la forme de zones d'arrêt de canal.

12. Procédé suivant la revendication 10,
- dans lequel, pour la production des structures (a) qui empêchent la formation de canaux, on dépose du matériau isolant, en remplissant ainsi les premiers sillons (G1),
- dans lequel on élimine le matériau isolant par un procédé photolithographique au moins de parties des deuxièmes flancs des premiers sillons (G1) et on produit ainsi, à partir du matériau isolant, les structures (a) qui empêchent la formation de canaux.

13. Procédé suivant l'une des revendications 9 à 12,
- dans lequel on effectue une implantation après la production des premiers sillons (G1), en produisant ainsi sur des fonds des premiers sillons (G1) des lignes (B) de bits qui agissent en partie en tant que deuxième zone de source/drain des transistors, et on produit la zone (GE) sous la forme de bandes à la surface (O) du substrat (1).
